# EUROPEAN PATENT APPLICATION

(11) **EP 2 645 427 A1**
(43) Date of publication of application: **02.10.2013**
(21) Application number: 12162074.4
(22) Date of filing: 29.03.2012
(51) Int. Cl.: H01L 31/18, H01L 31/0224

(54) **Extended laser ablation in solar cell manufacture**

(71) Applicant: Photovoltech N.V., 3300 Tienen (BE)
(72) Inventor: Moors, Matthieu, 1440 Braine-le-Château (BE); Duerinck, Filip, 3300 Tienen (BE); Van der Heide, Arvid, 3300 Tienen (BE); Szlufcik, Jozef, 3012 Leuvem (BE)
(74) Representative: Leyder, Francis

(57) **Abstract**

A rear-contacting technique for PERC cells is described, based on the simultaneous ablation of the metal and the dielectric(s) layer, followed by a firing step. This method provides solar cells having a higher efficiency, typically above 19%.

The method for electrically contacting a semi-conductor layer with a metal layer, said layers being separated by at least one dielectric layer, comprises the steps of:
- locally forming a crater by ablating the metal layer, the at least one dielectric layer and, at the same time, by creating a recess in the semi-conductor layer; then
- applying a thermal treatment (firing) with a peak temperature greater than the melting temperature of the metal layer.

## Description

### Field of the invention

The present invention is related to a method for producing a semiconductor-metal contact through a dielectric layer or stack in the fabrication of photovoltaic devices such as solar cells. More particularly it relates to electrically locally contacting a semiconductor layer coated with a dielectric layer or stack with a metal layer on the non-illuminated surface of a solar cell and to the formation of high quality local back surface fields.

### Technological background

A solar cell is a device that converts sunlight to electrical energy. It is generally based on a semi-conductor wafer (most commonly silicon). In its basic design, a solar cell can be divided in three regions: (1) the emitter (n- or p-doped), (2) the base (p- or n-doped, respectively) and (3) the p-n junction, localized between the emitter and the base. Since the emitter and the base present an opposite doping, a p-n junction is formed between them and develops an electrical field. If an incoming photon is absorbed in the cell, it can lead to the excitation of an electron from the valence band to the conduction band of the semi-conductor wafer, thereby forming a so-called electron-hole pair. Both electrons and holes are commonly named charge carriers. The electrical field developed in the junction allows those light-generated carriers to get separated and to drift in opposite directions (e.g. electrons towards the emitter if an n-type emitter is used). If the emitter and the base are connected by metal contacts, the charge carriers can escape the solar cell and carry electrical energy outside it.

Metal contacts on the illuminated side of the cell are commonly made from silver and designed as a grid that presents a high number of thin fingers (typically 100 um wide) connected to a few wider ones (usually two or three), called busbars. This grid pattern minimizes optical losses from reflection on the highly reflective metal. Concerning the non-illuminated side, a layer of aluminium is generally used, that covers the entire rear surface. In order to obtain an optimal electrical contact, this aluminium layer is commonly alloyed with the semi-conductor itself using a high temperature treatment (typically 800°C).

Since electron-hole pairs tend to recombine shortly after having been formed, and since the recombination phenomenon is particularly critical on the surfaces of the solar cell, the passivation of semi-conductor wafers by dielectric layers is known to provide solar cells with higher efficiencies. It indeed minimizes surface and bulk recombination phenomena and thereby increases the lifetime of charge carriers before they recombine.

Blakers and Green (Appl. Phys. Lett. 48(3) 215-7, 1986) disclosed passivated emitter solar cells (PESC cells).

When the non-illuminated surface of a solar cell is covered with a layer of dielectric material separating it from a layer of metal covering the dielectric layer, an electrical contact must be established locally between the non-illuminated surface and the layer of metal.

Blakers et al. (Appl. Phys. Lett. 55(13) 1363-5, 1989) disclosed passivated emitter and rear solar cells (PERC cells).

Intense minority carriers recombination that would occur in the vicinity of those local contacts can be decreased by forming a highly doped area around them, called p+ or n+ regions in p-type or n-type silicon, respectively.

Wang, Zhao and Green (Appl. Phys. Lett. 57(6) 602-4, 1990) disclosed passivated emitter, rear locally diffused (PERL) solar cells with 24% efficiency, based on float zone wafers, by locally diffusing boron into contacts locally opened by photolithography at the rear of the cells which present a p-type silicon base. This highly doped p+ region, which induces a "Local Back-Surface Field" (L-BSF), repels electrons from the silicon-metal interface, thereby increasing their lifetime. Neither the local boron diffusion process as disclosed (deposition at 900°C for 15 min followed by drive-in at 1070°C for 2h), nor photolithography are however industrially applicable in a cost-effective manner, not to mention that float zone wafers are known to be expensive to produce. There is therefore a need for an industrially applicable method. Although the potential advantages had been known for some time, the difficulty was (and remains) to find conditions which allow for the creation of a highly doped p+ region surrounding the contact areas (PERL cell) without lowering the exceptionally high bulk carrier lifetimes demonstrated in passivated emitter and rear cells (PERC cells).

A method (called "laser ablation" or LA) for contacting the rear side is known from the publication of R. Preu et al. entitled "Laser Ablation -A New Low-Cost Approach for Passivated Rear Contact Formation in Crystalline Silicon Solar Cell Technology", Proceedings of the 16th European Photovoltaic Solar Energy Conference, Glasgow, Scotland, 2000. There, the rear side of a solar cell is contacted by applying first a passivating dielectric coating over the entire area, which coating is subsequently locally opened by means of a laser with short pulses. Then, an aluminium layer is applied over the entire area. An electrical contact is created by heating the wafer up to 400°C or more. If a sufficiently high peak temperature is reached, the Si-Al alloying process takes place. An Al-doped p+ silicon layer (acting as L-BSF) may eventually be formed around the local contacts during recrystallization of the melt that occurs in the cooling phase. However, it is believed that silicon migrates during the final heating step into the aluminium whilst the latter is molten, leading to less efficient light trapping resulting from a lower internal reflectance of the final solar cell; this important silicon migration out of the local contacts is also believed to induce an L-BSF of insufficient thickness. In addition, if screen printing of the metal layer is used after laser ablation, voids are frequently observed in the contacts, leading to excessively thin BSF (which may even be absent) and poor electrical performances (in particular to low Voc values). Those voids are also believed to be related to excessive silicon dispersion and loss in the aluminium layer during the firing step, as disclosed by E. Urrejola et al. in Applied Physics Letters, 98 (2011) 153508.

It has been proposed to create an electrical contact by using a laser. This technique is generically called "laser-fired contact" or LFC.

US-6,982,218-B2 discloses an LFC method of electrically contacting a semiconductor layer coated with at least one dielectric layer which is coated with a metal layer. In this method, the metal layer is applied on the dielectric layer and the metal layer is temporarily locally heated by means of a source of radiation in such a way that a local molten mixture is formed consisting exclusively of the metal layer, the dielectric layer and the semiconductor layer is located directly underneath the metal layer and, upon solidification, leads to an electrical contact between the semiconductor layer and the metal layer.

However, obtaining the molten mixture of US-6,982,218-B2 requires the metal layer to be relatively thin (typically below 10 um), as obtained for example by physical vapour deposition or by sputtering. It would be expected that, in order to apply LFC technology to thicker metal layers, such as obtained with screen printing of a conductive paste, more energy would be required, leading to ablation of matter instead of creating a molten mixture as disclosed in US-6;982,218-B2, so that the back surface field layer (shown as (15) in the figures of US-6,982,218-B2) would be difficult to form. A thin local back surface field (below 1µm) is for example obtained when applying the LFC method on a screen-printed aluminium layer as disclosed by L. Gautero et al. in their communication entitled "Characterization of Aluminium screen-printed local contacts" and presented at the 2nd metallization workshop for crystalline silicon solar cells, in Konstanz, Germany, 2010. This method also requires a consecutive annealing step at moderate temperature (around 350°C) in a forming gas atmosphere (Forming Gas Anneal or FGA) to cure the damage induced to the substrate during the laser process. This requirement has been presented, for example, by C. Schwab et al. in their communication entitled "Screen-printed Al pastes for LFC solar cells" and presented at the 3rd metallization workshop for crystalline silicon solar cells, in Charleroi, Belgium, 2011.

### Aim of the invention

It is an aim of the invention to provide a method of electrically contacting a semiconductor layer coated with a dielectric layer with a metal layer on a surface of a solar cell, which alleviates or avoids some problems of the prior art.

It is an aim of the invention to provide a method of electrically contacting a semiconductor layer coated with a dielectric layer with a metal layer on a surface of a solar cell which alleviates or avoids some problems of the prior art by forming a thick and continuous p+ layer around the contacts (Local Back Surface Field).

It is an aim of this invention to provide a method for producing a photovoltaic cell having an improved open circuit voltage (Voc) and/or an improved short-circuit current (Isc) and/or an improved fill factor, so that a photovoltaic cell is obtained having an improved global efficiency.

### Summary of the invention

The method of the invention for electrically contacting a semi-conductor layer with a metal layer, said layers being separated by at least one dielectric layer, comprises the steps of:
- locally forming a crater by ablating the metal layer, the at least one dielectric layer and, at the same time, by creating a recess in the semi-conductor layer; then
- applying a thermal treatment (firing) with a peak temperature greater than the melting temperature of the metal layer.

According to an embodiment of the invention, the walls of the crater are covered at least partially with silicon up to and including the metal layer before the firing step.

According to another embodiment of the invention, the method of the invention uses a laser beam to create the recess in the silicon layer, preferably also to cover the walls of the crater up to and including the metal layer at least partially with molten silicon, projected from the recess during the laser treatment, before the firing step. The laser is preferably used in pulsed mode.

### Description of the figures

Fig 1 shows a laser (1) sending a pulse (2) on a semiconductor layer (5) covered with a metal layer (3), said layers being separated by at least one dielectric layer (4), the semiconductor layer being provided with an emitter (6) on the other side.
Fig 2 shows the same after a laser pulse, with semiconductor from the recess covering the walls of the crater.
Fig 3 shows the connection after firing, with the metal-semiconductor alloy(7) and the p+ layer (Local Back-Surface Field) (8).
Fig 4 shows electrical parameters measured on PERL cells passivated using a SiO₂/AlOₓ/SiNₓ stack on the rear; an LFC process and the process of the invention are compared, and two inter-contact distances are tested (0.3 and 0.5mm).
Fig 5 is a picture of a cross-section at the bottom of a recess, obtained after an extended laser ablation but before firing, with a scanning electron microscope (SEM).
Fig 6 is the same as Fig. 5, after firing.

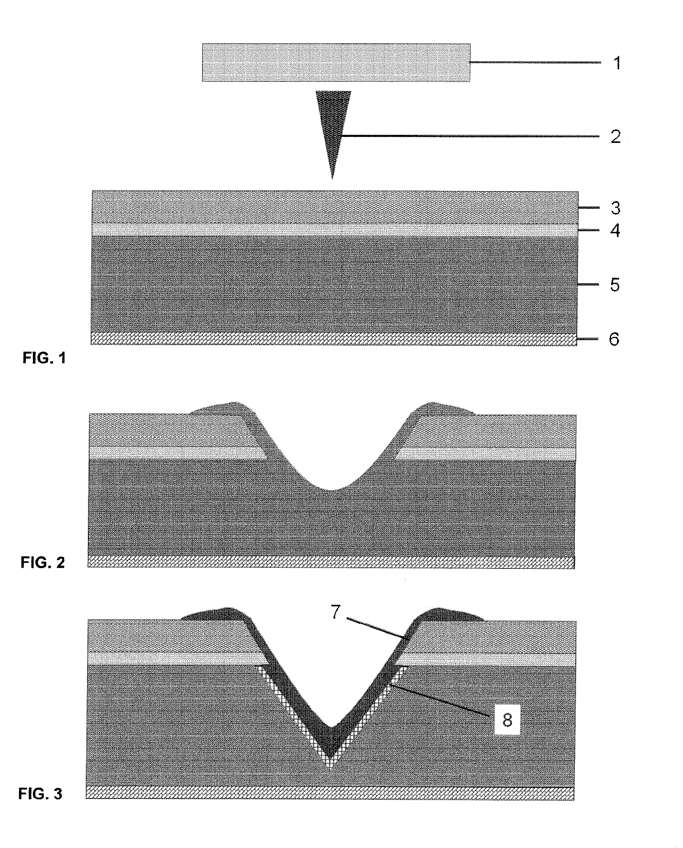

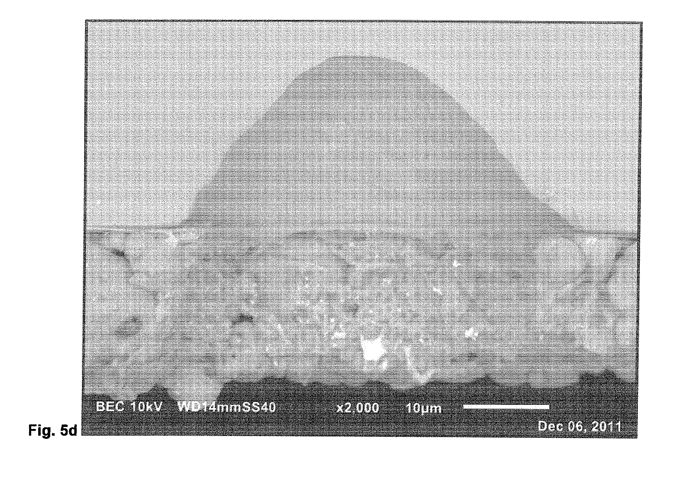

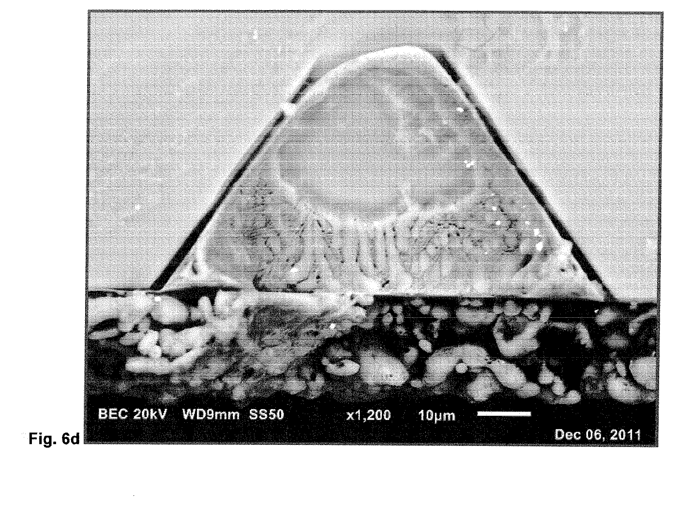

Fig. 5d and 6d will be published as Fig. 3a and 3b respectively in Proc. 2nd Silicon PV Conf., Leuven, 3-5 April 2012 and in the Solarmat journal.

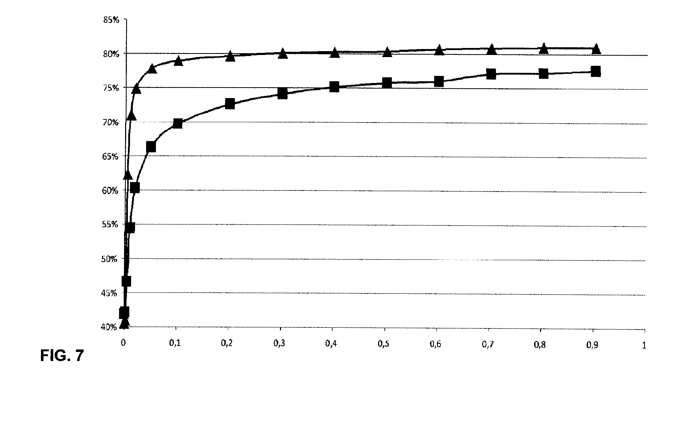

Fig. 7 shows the external quantum efficiency at various bias light intensities for Example 2 and comparative example B.

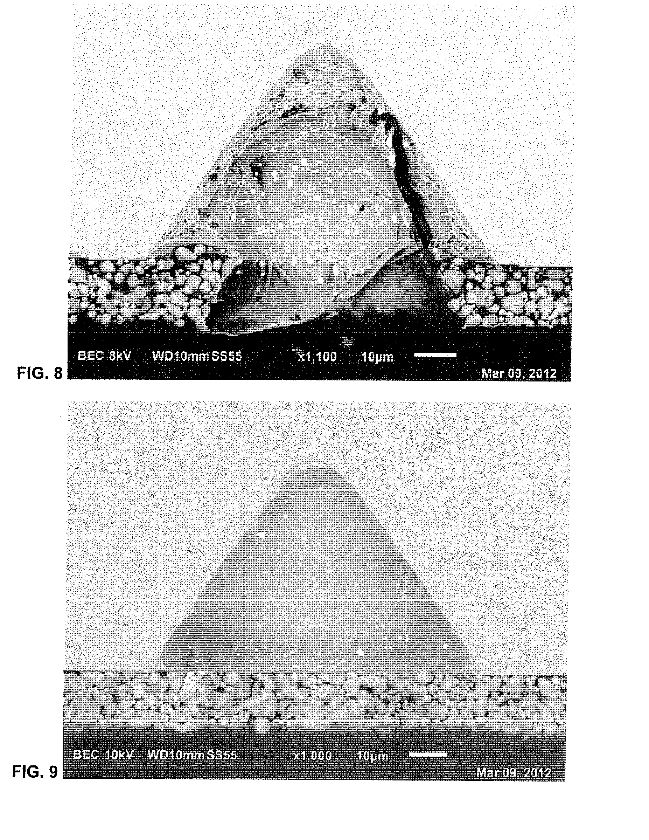

Fig. 8 presents a SEM picture of a contact obtained with the process of the invention, filled by Al-Si eutectic (see Example 4)
Fig. 9 presents an SEM picture of an empty contact obtained as per Comparative Example D).

### Detailed description of the invention

The method of the invention is particularly applicable for contacting p-type silicon, either as base of cells based on p-type silicon wafers, or as front- or rear-emitter of cells based on n-type silicon wafers. It is applicable to photovoltaic cells of all types; it is particularly applicable to MWT-PERC (passivated emitter and rear cell) cells.

The method of the invention is applicable to multi-crystalline silicon as well as to mono-crystalline (Cz or cast) silicon, using starting wafers of any size, shape and sufficient thickness (e.g. of at least 40 um).

The silicon wafer is covered firstly with at least one layer of dielectric material, usually selected from SiNx, SiOx, AlOx and SiCx. Plasma-Enhanced Chemical Vapor Deposition (PE-CVD), Atomic Layer Deposition (ALD), and/or a combination of them, are preferentially used for this purpose. Other techniques can also be appropriate (for example, Atmospheric Pressure-CVD, thermal oxidation (dry or wet) and chemical oxidation).

A metal layer is then deposited on top of the deposited dielectric(s), usually selected from aluminium and alloys thereof. The method of the invention is particularly applicable to screen-printing metal deposition techniques. Other methods can also be used for this purpose (for example: evaporation, sputtering, laser transfer). The layer usually has a thickness of about 15 to about 30 um, most commonly of about 25 um, but layers as of less than 15 um can be used.

A preliminary thermal treatment is eventually applied to the wafer after the deposition of the metal layer to get it dried, free of detrimental contaminants and to obtain a good adhesion to the dielectric-covered surface. If this treatment is needed, it should preferably, but not necessarily, be achieved before the formation of any other contacts to avoid any degradation of them.

The method of the invention for electrically contacting the semi-conductor layer with the metal layer, said layers being separated by at least one dielectric layer, then comprises the steps of:
- locally forming a crater by ablating the metal layer, the at least one dielectric layer and, at the same time, by creating a recess in the semi-conductor layer; then
- applying a thermal treatment (firing) with a peak temperature greater than the melting temperature of the metal layer.

This method has been called extended laser ablation (or ELA).

According to an embodiment of the invention, the walls of the crater are covered at least partially with silicon up to and including the metal layer before the firing step.

According to another embodiment of the invention, the method of the invention uses a laser beam to create the recess in the silicon layer, preferably also to cover the walls of the crater up to and including the metal layer at least partially with silicon before the firing step. The laser is preferably used in pulsed mode.

The laser can be used either in a continuous wave mode or a pulsed mode to create a pattern of contact points or lines. The methods for creating patterns are known in the art (see e.g. US-6,982,218-B2).

When many contacts need to be made, it is preferred to use a laser that generates pulses and to displace the laser beam at a speed adapted to the frequency of the laser in order to obtain the desired pattern on the wafer. This may result in craters having a slightly oval opening, however without significant consequences on the resulting properties.

The pulse energy should be sufficient to simultaneously locally ablate the metal layer, the at least one dielectric layer and, at the same time, creating a recess in the semi-conductor layer. After the pulse, the walls of the crater should preferably be covered at least partially with molten silicon projected from the recess, up to and including the metal layer, most preferably be covered completely with silicon up to and including the metal layer.

The laser pulse length is preferably comprised between 500 ns and 2000 ns According to an embodiment of the invention, the wafer can be placed in an atmosphere of inert or reducing gas during the extended laser ablation. Suitable gases include N2, H2, forming gas (N2-H2 mixture), or noble gases.

After the extended laser ablation, the wafer is submitted to a thermal treatment, during which care is to be taken to keep silicon diffusion into the aluminium layer to a minimum (and to avoid degradation of front-side contacts if any). During this firing step, the wafer should be fired at a temperature and for a period of time sufficient to allow the alloying process between aluminium and silicon to occur locally. It is believed that this maximises the thickness of the Al-doped L-BSF layer.

The minimum wafer peak temperature should be of at least 660°C (which is the melting temperature of aluminium), preferably at least 700°C, more preferably at least 750°C, and the temperature reached should exceed 660°C for at least 1 s, preferably between 2 and 10 s. The peak temperature should not exceed 1000°C, preferably 900°C, more preferably 860°C, most preferably 840°C. The temperature profile should provide a fast firing profile, preferably a very sharp, spike-like profile. Indicated temperatures are measured using a type-K thermocouple fixed to a wafer and passed through the oven.

This firing step can be used simultaneously as the thermal treatment needed to form any other electrical contacts of the cell.

Whilst not wishing to be bound by a theory, it is believed that this firing step provides a thick and continuous local p+ layer that surrounds the contacts (local back-surface field); it is further believed that the high quality L-BSF obtained with this method is related to a minimal silicon escape from the contact to the metal layer, favoured by three concepts:
- silicon that covers the walls of the crater is the one that preferentially migrates into the metal layer, thereby preventing migration of silicon from the semi-conductor layer.
- the physical volume assigned for Al and Si mass transport is limited (edges of the crater).
- the recess formed by the laser ablation step in the Si layer exposes surfaces near {111} Si crystal planes that are denser and less reactive towards dissolution than the initially exposed {100} plane of the wafer, thereby slowing down Si diffusion out of the contacts.

During the cooling stage of the firing step, the silicon content of the Al-Si melt gradually decreases down to the eutectic composition of about 12 mol% of Si, before solidifying at 577°C. To allow for this gradual concentration evolution, the excess Si continuously crystallizes epitaxially on the recess surfaces with an Al content below 1 mol% (the solubility limit of Al in solid Si) to form the p+ phase (L-BSF).

The eutectic Al-Si layer that covers the inner walls of the contacts may contain "holes" resulting from a non-continuous eutectic layer. The presence and size of these "holes" is minimised by conducting the firing as disclosed herein. It is believed that such "holes" can be associated with interruptions in the L-BSF layer that should surround the recess but have a negligible influence on the cell properties, and do not prevent the cell properties to be better than in the prior art. Whilst not wishing to be bound by a theory, it is believed that these holes preferentially appear if silicon escape from the contact remains important during the firing step. This effect can eventually be minimized by selecting short inter-contact distances (below 0.45mm), by diminishing the firing peak temperature, or by using specially designed aluminium conductive pastes (e.g. Si-containing, see for example US 7,842,596 B2).

Typically, the temperature is increased above 660°C during about 5 sec, with a peak of about 800°C, cooling down to 577°C after a total of about 8 sec.

According to an embodiment of the invention, there is used an aluminium paste that only requires a low-temperature drying treatment (below 400°C) before the extended laser ablation step. In a preferred embodiment, the thermal treatment achieved after the extended laser ablation is combined with the firing required for the contacts on the front-side of the cell.

### EXAMPLES

### Cell properties

The electrical parameters of the cells have been measured using a Berger Solar Simulator, in which a flash lamp simulates the AM1.5 sunlight spectrum (Air Mass 1.5 is defined as the light passing an atmosphere of 1.5 * normal atmosphere thickness) to illuminate a cell with a standard irradiance of 1000W/m² ("one sun") at 25°C.

The electrical parameters of the cell were measured (Isc and Voc) and computed (Impp and Vmpp) during the light flash by drawing its current-voltage curve (I/V) whilst applying a variable resistance to an externally connected "load". From these values, Jsc (normalized Isc), the Fill Factor (FF) and efficiency (η or eta) were computed. The Fill Factor reflects the series and shunt resistance losses.

### EXAMPLE 1

### Silicon wafer

The wafer used was a 156 mm x 156 mm x 200 um wafer of mono-crystalline (Cz) p-type silicon, having a resistivity around 2 ohm.cm.

### Saw damage removal, surface texturing and cleaning

Using an in-line wetbench, the wafer was subjected to a series of surface treatments:
- removal of organic contaminants at room temperature;
- rinsing (always using deionised water);
- surface texturing using an alkaline solution
- rinsing;
- metal removal using a HF/ HCl solution at room temperature;
- rinsing;
- drying.

### Back-side polishing

Using an in-line wet-bench, the surface designed to be the non-illuminated surface was subjected to a series of surface treatments, as described in a publication by S. Queisser et al. (Proc. 24th European Photovoltaic Solar Energy Conference, 21-25 September 2009, Hamburg, DE). The wafers are moved through a series of baths, only the back side being in contact with the solution (hence its name "Single Side Polishing"). The process sequence essentially consists of:
- a process bath containing HF and HNO3;
- a first rinse;
- an alkaline rinse;
- a second rinse;
- an acidic rinse;
- a third rinse; and
- a final drying.

### Emitter formation

A 75 ohm/square emitter was formed on all surfaces in a diffusion furnace using POCl3 at 850°C.

### Wet edge isolation

Using an in-line wet-bench, the surface designed to be non-illuminated was subjected to a single-side treatment (comparable to the one described above) aiming at etching a thin silicon layer on the wafer rear-side and edges in order to remove the emitter. In addition, the phosphorus-silicate glass (PSG) was removed from both sides of the wafer.

### Aluminium oxide deposition

A thin layer (10-12 nm) of AlOx is then deposited on the non-illuminated surface.

### Silicon nitride deposition

In a PE-CVD apparatus, a layer of approximately 100nm silicon nitride was deposited on the front- and rear-surfaces.

### Front contacts

The front contacts were screen-printed using conventional screen printer. A pattern of conductive silver paste was screen-printed on the wafer front-side to create 3 busbars (1.5 mm wide) and 84 fingers (80 um wide). A drying process was achieved in an oven at a temperature around 200°C for 1 min.

### Back side aluminium layer

An aluminium layer was screen-printed at the back side using a conventional screen-printer. Conductive aluminium paste was screen-printed on the wafer rear-side on an area of 154 mm x 154 mm. A drying process was achieved in an oven at an object temperature of 200°C, thereby obtaining a thin layer of about 12 to 15 um.

### First Thermal Treatment

The wafer was then fired in an infra-red belt furnace. The time above 660°C and 750°C was respectively of 3.3 s and 1.35 s, and the peak temperature was of 790°C.

### Extended laser ablation

The laser used was an infrared disk laser operating at a wavelength of 1030 nm. The laser generated pulses, each pulse having a duration of 0.001 to 0.002 ms and an energy of 0.8 mJ, and creating a crater having a diameter of about 70 um. The recess formed in the silicon layer was approximately 30 um deep.

A squared matrix of craters was made at the back of the wafer, with a 0.4 mm pitch (obtained by adapting the speed at which the laser beam was displaced over the wafer to the frequency of the laser, which was of 22.2 kHz), to cover the entire surface of the wafer.

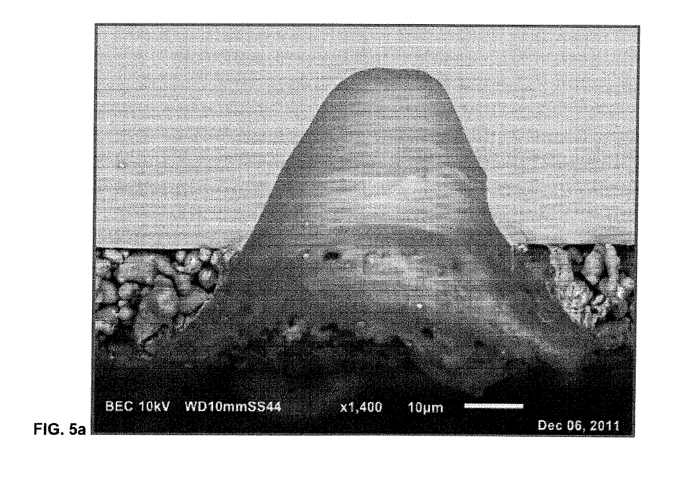

Fig 5a is a picture of a cross-section at the bottom of a crater, obtained with a scanning electron microscope. The silicon layer is at the top. It shows that a hole was created through the aluminium layer into the silicon layer, and that the material from the hole is ablated i.e. removed.

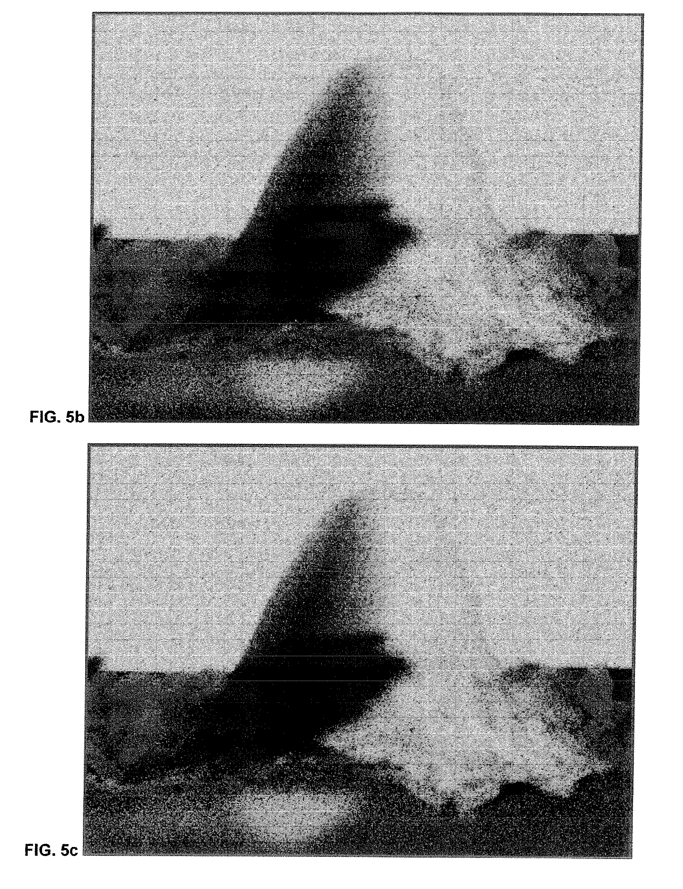

Fig 5b and 5c show the elemental map corresponding to Fig. 5a, obtained by energy-dispersive X-Ray spectroscopy (EDS or EDX). On the colour photograph (Fig 5b), silicon is shown in green and aluminium in red. On a gray shade version (Fig 5c), the silicon is light grey and the aluminium dark grey. On both versions, the dark area on the left of the crater is the area not visible by the detector. These figures show that the surface of the crater is partially covered with silicon projected from the recess during the laser pulse.

Another contact on the same cell was chemically dipped during 22 seconds with a HF (50%):HNO3 (69%)-HAc (100%) in a 1:3:6 volume ratio. This operation specifically dissolves the p+ layer. Fig. 5d is a picture of a cross-section at the bottom of the crater, obtained with a scanning electron microscope. It can be seen that there was no p+ layer.

### Second Thermal Treatment

The first thermal treatment described above was repeated.

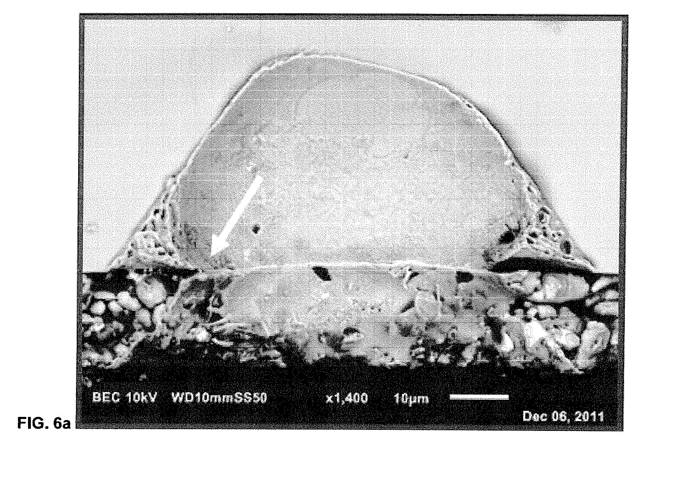

Fig 6a is a picture of a cross-section close to the bottom of a crater, obtained with a scanning electron microscope. It shows that the second firing step enlarged and reconstructed the hole up to the [111] crystal planes. The white arrow shows the original crater wall, still visible in the aluminium layer (also on the other side).

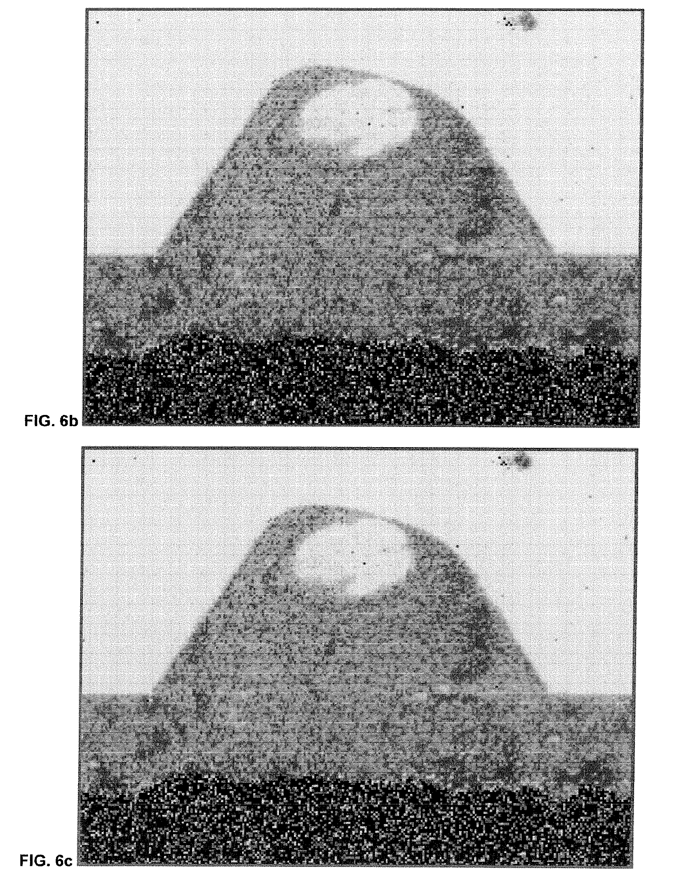

Fig 6b and 6c show the elemental map corresponding to Fig. 5a, obtained by energy-dispersive X-Ray spectroscopy (EDS or EDX). On the colour photograph (Fig 6b), silicon is shown in green and aluminium in red. On a gray shade version (Fig 6c), the silicon is light grey and the aluminium dark grey. On both versions, it can be seen that the walls of the crater are now predominantly aluminium: quantitative measurements using EDS shows that this is actually the Al-Si eutectic containing about 12% silicon.

Whilst not wishing to be bound by a theory, it is believed that the silicon area in the crater (as can be observed in Fig. 6) is not detrimental to the electrical properties of the cell.

Another contact on the same cell was chemically dipped during 22 seconds with a HF (50%):HNO3 (69%):HAc (100%) in a 1:3:6 volume ratio, to specifically dissolve the p+ layer. Fig. 6d is a picture of a cross-section at the bottom of the crater, obtained with a scanning electron microscope. It can be seen that there was a p+ layer, which appears black on the picture (compare with Fig. 5d).

### Cell properties

The following values were obtained for the electrical parameters. The reproducibility (2 sigma) was evaluated on the basis of results obtained with several cells, using a flash light source.
Voc 635 mV (1)
Jsc = 38.5 mA/cm2 (0.05)
FF = 77.75 % (0.1)
Efficiency = 19.0 % (0.05)

The efficiency is outstanding regarding the relative simplicity of the process (no supplementary cleaning step, no annealing in a forming gas). The high Voc value shows that the BSF layer is of good quality.

The best cell was sent to the independent laboratory ISE CalLab for measurements after light soaking, using a steady state light source. The results were as follows:
Voc = 636.9 ± 1.9 mV
Jsc = 38.18 ± 0.73 mA/cm2
FF= 78.66 ± 0.51 %
Efficiency = 19.13 ± 0.38 %

### COMPARATIVE EXAMPLE A

A cell was prepared according to example 1 however the electrical parameters were determined before the second thermal treatment.
Voc = 631.5 mV (1)
Jsc = 38.3 mA/cm2 (0.05)
FF 77.5 % (0.1)
Efficiency = 18.75 % (0.05)

The efficiency is good. This shows that the second thermal treatment improves the Voc and Jsc values, and the improvement is attributed to the creation of a BSF layer of good quality. Also, the improvement in the FF due to the second firing is believed to be due to the creation of the eutectic Al-Si on the surface of the crater.

### EXAMPLE 2

### Example 1 was repeated, with two differences:

(1) the cell was subjected to a dry thermal oxidation between the wet edge isolation and the aluminium oxide deposition; and
(2) the squared matrix of craters made at the back of the wafer had a 0.5 mm pitch.

### Dry thermal oxidation

A thin layer of silicon oxide was grown on all surfaces of the wafer using a diffusion furnace at 800°C during 60 minutes.

### Cell properties

The following values were obtained for the electrical parameters. The reproducibility (2 sigma) was evaluated on the basis of results obtained with several cells, using a flash light source.
Voc = 640 mV (1)
Jsc = 38.0 mA/cm2 (0.05)
FF= 78.3% (0.1)
Efficiency = 19.0 % (0.05)
The efficiency is outstanding.

The best cell was evaluated using a steady state light source, after calibration of the tool using the best cell of example 1 and the independently obtained values:
Voc = 640.8 mV
Jsc = 37.7 mA/cm2
FF = 80.65 %
Efficiency = 19.48 %

### COMPARATIVE EXAMPLE B

A cell was prepared according to example 2, however the electrical parameters were determined before the second thermal treatment, using a flash light source.
Voc = 634.8 mV (1)
Jsc = 37.8 mA/cm2 (0.05)
FF = 76.7 % (0.1)
Efficiency = 18.4 % (0.05)

The efficiency is average. This shows that the second thermal treatment has an even more impressive effect.

Fig. 7 shows the external quantum efficiency (expressed in %) measured at 1050 nm at various bias light intensities (expressed as fractions of sun). The values for Example 2 are represented with triangles, and those for comparative example B with squares.

When SiOₓ was used to passivate the rear-side of the cells of example 2 and comparative example B (both made from p-type silicon), fixed positive charges developed at the Si-SiOₓ interface and repelled holes away from it, inducing a local accumulation of electrons. This electron rich layer then acted as a "floating junction" and repelled incoming electrons (thus decreasing the surface recombination velocity and increasing their effective lifetime).

In Fig. 7, the curve for Example 2 (values shown as triangles) shows that the metal contacts formed across this floating junction did not act as severe recombination centers because they were shielded by an efficient surrounding, Al-doped, p+ layer (or Local Back-Surface Field, L-BSF) which prevent leakage of electrons. To the contrary, such leakage is visible in Comparative example B: a less effective or even absent L-BSF induced a so-called "inversion layer shunting" effect, resulting in poor cell performances, particularly visible at low injection level (i.e. at low bias light levels; values shown as squares).

### EXAMPLE 3

Example 2 was repeated, with two differences:
(1) increasing the object temperature for drying the aluminium paste to 300°C; and
(2) omission of the first thermal treatment (Extended Laser Ablation step is achieved directly after the aluminium drying step).

### Cell properties

The following values were obtained for the electrical parameters. The reproducibility (2 sigma) was evaluated on the basis of results obtained with several cells, using a flash light source.
Voc = 621 mV (1)
Jsc = 37.4 mA/cm2 (0.05)
FF = 79.6 % (0.1)
Efficiency = 18.5 % (0.05)

The efficiency is not as good as for example 2, however it is believed that it would still be possible to improve this value by further increasing the drying temperature and/or selecting a conductive aluminium paste better suited to this embodiment.

### COMPARATIVE EXAMPLE C

A cell was prepared according to example 3, however stopping before the (only and) last cell firing. Since there had been no firing step, the cell was not contacted.

### EXAMPLE 4 AND COMPARATIVE EXAMPLE D

Example 2 was repeated on two wafers. The first one (Example 4) followed exactly the procedure described in Example 2 but two differences have been included concerning the second wafer (Comparative Example D):
(1) the dielectric layers have been locally laser-ablated, forming a matrix of round openings with an inter-contacts distance of 0.4mm. A Q-Switched UV Laser (355nm - nanosecond pulse length) has been used for this purpose.
(2) the sample has then been metallised (front side Ag and rear Al by screen-printing, like in example 1) and contacted using twice the firing step described in example 1.

In other words, the first wafer followed the rear-contacting method described in this patent, while the laser ablation technique has been used for the second one (as proposed by R. Preu et al. in "Laser Ablation -A New Low-Cost Approach for Passivated Rear Contact Formation in Crystalline Silicon Solar Cell Technology", Proceedings of the 16th European Photovoltaic Solar Energy Conference, Glasgow, Scotland, 2000).

Figure 8 presents a SEM picture of an individual contact imaged from the first wafer (Example 4, using extended laser ablation) while Figure 9 presents an SEM image of a contact of the second wafer (Comparative Example D). The contact presented on Figure 9 is empty while the ELA_contact is filled by the Al-Si eutectic (Figure 8). The ELA process thus minimizes Si loss from the contacts, avoids voiding issues and allows thicker p+ layers to be produced around them.

### Scientific Discussion

Although leading to high-quality solar cells, a major drawback the LFC contacting protocol we developed is that the single-pulse laser process, if used on screen-printed samples, does not create the thick and continuous p+ layer (L-BSF) that should ideally surround the local contacts of the PERL architecture. The absence of L-BSF (see Figure 5.d), which can be considered as switching back from a PERL to a PERC cell design, is not strongly detrimental when an AlOₓ-based rear-passivation layer is used. In this case indeed, fixed negative charges build-up at the Si-AlOₓ interface and directly repel minority carriers from the base surface (electrons for a p-type base) [ G. Agostinelli et al., Solar Energy Materials and Solar Cells, 90(18-19) (2006) 3438.]. On the contrary, when a SiO₂-based passivation is chosen, fixed positive charges are developed, leading to the formation an electron-rich inversion layer close to the surface, often called *floating junction* [P. P. Altermatt et al., Journal of Applied Physics, 80(6) (1996) 3574.]. As this floating junction needs to remain uncontacted to provide efficient surface passivation, the presence of an electrons-repelling p+ layer around each local contact is crucial to screen-off the metal layers from the inversion layer, thereby avoiding intense recombination and efficiency losses *(inversion layer shunting effect* [S. Dauwe et al., Progress in Photovoltaics: Research and Applications, 10 (2002) 271.]). In agreement with the low-quality L-BSF we observed, solar cells of low efficiencies have been produced when using LFC together with positively charged SiO₂/AlOₓ/SiNₓ passivation stacks. A new rear-contacting method has thus been developed to improve the quality of local back-surface fields.

This method, that we called Extended Laser Ablation or ELA, is based on the local ablation of both the aluminium layer and the dielectric stack in a single laser pulse. The advantage of this new technique is that it (1) provides local contacts with a thick and continuous L-BSF layer surrounding them, (2) that it preserves the internal reflectance of the cell, and (3) that it prevent the unwanted contact voiding effect often presented in the literature [E. Urrejola et al., Applied Physics Letters, 98 (2011) 153508.]. Figure 5 and 6 present SEM micrographs of individual PERL contacts created using the LFC (Fig.5.d) and the ELA (Fig.6.d) methods, which received a chemical treatment to delineate the Al-doped p+ phase. One can observe that the LFC contact barely presents any L-BSF while the ELA method provides a thick (∼2.5µm) and continuous one.

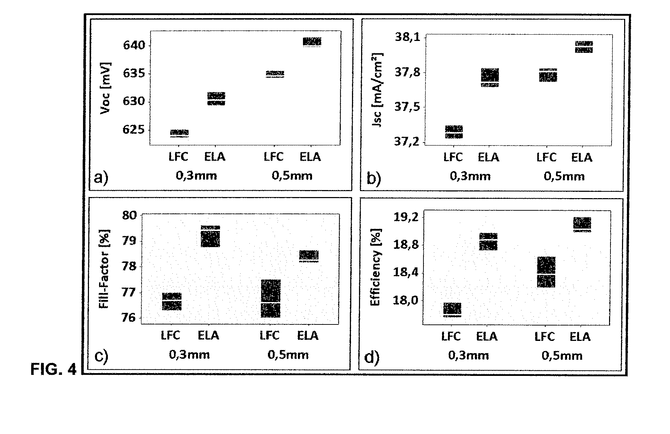

Both rear-contacting processes have then been implemented in our PERL process flow in order to compare their performances at cell level. In this experiment, a SiO₂/AlOₓ/SiNₓ rear-passivation stack is used, created by growing a thin thermal oxide on both rear and front surfaces before AlOₓ deposition. I-V parameters of the related cells are presented in Figure 4. When this positively charged rear-passivation design is used, the ELA process provides higher cell efficiencies (approximately 0.6% abs., see Fig.4.d) than the LFC method. As explained above, the latter indeed leads to lower quality L-BSF and to the related *inversion layer shunting* effect, causing important Jsc and Voc losses (Fig.4.a and 4.b).

The reasons why higher fill-factor values are obtained with the ELA process are still unclear. They could be related to the inner coating of the contacts by a thicker layer of the Al-Si eutectic phase in the ELA case which could result in lower contact resistances. This eutectic compound is indeed barely observable on the contact walls when the LFC process is used (see Figure 5.d). A study of individual contact resistances of LFC and ELA contacts will be realized in the near future, using a dedicated characterization protocol.

Finally the ELA process has also been tested and compared to LFC-PERL cells when using rear AlOₓ/SiNₓ passivation stacks. Improvements of electrical parameters, as compared to LFC-processed cells, are less pronounced than in the case of SiO₂-based rear-passivation, as the L-BSF quality becomes less critical. But an efficiency gain of 0.2% absolute is still observed. The following table presents the best ELA-PERL cells obtained till now. It gives Electrical parameters of best ELA-PERL cells processed at Photovoltech using two different rear-passivation stacks. The measurements of the first cell have been independently confirmed by ISE Callab after light soaking. The second one has been characterized in-house using a DC-tester calibrated using the first cell.

| | Voc [mV] | Jsc [mA/cm²] | Fill-Factor [%] | Efficiency [%] |
|---|---|---|---|---|
| Extended Laser Ablation - AlOₓSiN_{X} passivation | | | | |
| Best Cell | 636.9 | 38.18 | 78.66 | 19.13 |
| Extended Laser Ablation - SiO₂-AlOₓ-SiNₓ passivation | | | | |
| Best Cell | 640.8 | 37.70 | 80.65 | 19.48 |

The laser-fired contacts metallization process has first been optimized and implemented in our pilot production line, aiming at finding the best compromise between low contact resistance and minimal laser damage. High efficiency PERL cells have been obtained when using this process with AlOₓbased passivation schemes but inversion layer shunting effects were encountered with SiOₓ/AlOₓ/SiNₓStacks. To solve this issue, a new contacting method has been invented, called Extended Laser Ablation (or ELA). This technique provides higher quality L-BSF. The pilot production of ELA-PERL cells offered efficiencies up to 19.5% while preserving a cost-effectiveness and industrial up-scalable process flow (no FGA treatments, 75Ω/□ homogeneous emitter, fully screen-printed contacts and standard cleaning procedures).

## Claims

1. A method of electrically contacting a semi-conductor layer with a metal layer, said layers being separated by at least one dielectric layer, comprising the steps of:
- locally forming a crater by ablating the metal layer, the at least one dielectric layer and, at the same time, creating a recess in the semi-conductor layer; then
- applying a thermal treatment (firing) with a peak temperature greater than the melting temperature of the metal layer.

2. Method according to claim 1, wherein the walls of the crater are covered at least partially with semi-conductor up to and including the metal layer before the firing step.

3. Method according to claim 1 or 2, wherein a p+-doped layer is formed around the electrical contact (Local Back Surface Field).

4. Method according to any one of the preceding claims, wherein a laser beam is used to create the crater and the recess.

5. Method according to claim 4, wherein the creation of the crater and the recess results in covering the walls of the crater at least partially with semi-conductor up to and including the metal layer.

6. Method according to claim 4, wherein the laser is used in pulsed mode.

7. Method according to claim 6, wherein the laser pulse length is comprised between 500 ns and 2000 ns.

8. Method according to any one of the preceding claims, wherein the semi-conductor material is silicon.

9. Method according to any one of the preceding claims, wherein the metal layer contains aluminium, or a mixture of aluminium and silicon, or a mixture of aluminium and silver.

10. Method according to claim 9, wherein the metal layer is deposited by screen-printing or sputtering or evaporation or laser transfer.

11. Method according to any one of the preceding claims, wherein the at least one dielectric layer comprises of SiOx or AlOx or SiNx or SiCx or any combination thereof.

12. Method according to any one of the preceding claims, wherein the semiconductor layer is contacted with the metal layer by combination of contacted points and/or lines.
